Europäisches Patentamt

European Patent Office

Office européen des brevets

(11) Numéro de publication : **0 018 890**
**B1**

# (12) FASCICULE DE BREVET EUROPÉEN

(45) Date de publication du fascicule du brevet :
15.12.82

(21) Numéro de dépôt : **80400549.4**

(22) Date de dépôt : **23.04.80**

(51) Int. Cl.³ : **H 01 L 23/14**, H 01 L 23/48,
C 04 B 37/02

(54) **Support isolateur électrique, à faible résistance thermique, et embase ou boîtier pour composant de puissance comportant un tel support.**

(30) Priorité : 02.05.79 FR 7911023

(43) Date de publication de la demande :
12.11.80 (Bulletin 80/23)

(45) Mention de la délivrance du brevet :
15.12.82 Bulletin 82/50

(84) Etats contractants désignés :
DE GB IT NL

(56) Documents cités :
EP A 0 009 978
DE A 1 439 905
FR A 1 372 216
FR A 1 376 243
GB A 903 824
US A 4 042 952

(73) Titulaire : THOMSON-CSF
173, Boulevard Haussmann
F-75379 Paris Cedex 08 (FR)

(72) Inventeur : Resneau, Jean-Claude
"THOMSON-CSF" SCPI 173, bld Haussmann
F-75360 Paris Cedex 08 (FR)
Inventeur : Doyen, Jean
"THOMSON-CSF" SCPI 173, bld Haussmann
F-75360 Paris Cedex 08 (FR)
Inventeur : Ribier, Robert
"THOMSON-CSF" SCPI 173, bld Haussmann
F-75360 Paris Cedex 08 (FR)

(74) Mandataire : Giraud, Pierre et al
THOMSON-CSF SCPI 173, bld Haussmann
F-75379 Paris Cedex 08 (FR)

Support isolateur électrique, à faible résistance thermique, et embase ou boîtier pour composant de puissance comportant un tel support

L'invention concerne un support isolateur électrique, à faible résistance thermique, utilisable notamment pour un composant de puissance, tel qu'une diode ou un transistor à haute fréquence.

Les embases ou boîtiers comportant un tel support font partie de l'invention.

Dans un composant électronique de puissance dissipée relativement grande (de quelques watts à une centaine de watts ou même davantage) une grande quantité de calories prend naissance dans un petit volume, et l'on a recours, pour les évacuer, à un support dissipatif (l'embase) en métal bon conducteur de la chaleur et de l'électricité, lui-même en contact avec l'air ou un dispositif refroidisseur.

D'autre part, en haute fréquence (de quelques dizaines à quelques centaines de mégahertz ou même davantage), les connexions du composant doivent être très grandes par rapport aux dimensions de la ou des pastilles semiconductrices qui constituent la partie active du composant. Ces connexions ne sont pas alors directement branchées sur la ou les pastilles mais soudées à des métallisations déposées sur un support intermédiaire, électriquement isolant et thermiquement conducteur, indispensable pour assurer l'isolement électriquement d'une partie au moins des connexions, tout en permettant l'évacuation de la chaleur.

L'oxyde de béryllium fournit un matériau diélectrique de conductivité thermique ($0,6$ cal $\cdot$ s$^{-1}$ cm$^{-1}$) presque aussi bonne que celle de l'or ($0,7$ cal $\cdot$ s$^{-1}$ cm$^{-1}$) et dont le coefficient de dilatation thermique linéaire ($7,7 \cdot 10^{-6}$) est bien adapté à celui du silicium ($7,6 \cdot 10^{-6}$), ce qui permet la soudure de la pastille directement sur la métallisation de l'oxyde de béryllium.

Toutefois, un problème se pose lors de l'augmentation de puissance à une centaine de watts et au-delà, sur une surface de l'ordre du centimètre carré. En effet, pour favoriser l'évacuation de la chaleur, on cherche :

— soit à disperser les pastilles de semiconducteur sur la métallisation de l'oxyde afin que les cônes thermiques se recoupent au-dessous de l'oxyde de béryllium, c'est-à-dire dans l'embase métallique ou dans le dispositif refroidisseur : on a alors des disques de béryllium de grandes dimensions ;

— soit à diminuer, à surface équivalente, l'épaisseur d'oxyde de béryllium obtenant finalement un résultat analogue.

Dans les deux cas, on constate des fêlures dans l'oxyde BeO si l'on effectue un brasage à haute température, à l'alliage d'argent et de cuivre, qui est le seul compatible avec une bonne fiabilité. Si on se limite au brasage à basse température, avec des soudures dites tendres (alliage de plomb, d'argent et d'indium) on n'a pas de fêlures du BeO, mais la fiabilité est moins bonne.

On a proposé, dans le document FR-A-1 376 243, concernant une structure de scellement métal-céramique comprenant une pièce en céramique telle que le béryl et au moins une pièce métallique adjacente à celle-ci, de réaliser cette pièce métallique sous la forme d'un ensemble de tôles laminées, certaines de ces tôles présentant un coefficient de dilatation supérieur à celui de la pièce en céramique et certaines de ces tôles présentant un coefficient de dilatation thermique inférieur à celui de la pièce en céramique.

On a proposé, dans le document GB-A-903 824, concernant également une structure métal-céramique de type concentrique, de disposer entre métal et céramique, un corps intermédiaire de métal dont le coefficient de dilatation thermique est choisi de telle sorte que le coefficient de dilatation du matériau placé à l'extérieur soit intermédiaire entre celui du matériau placé à l'intérieur et celui du métal du corps intermédiaire.

L'invention tend à éliminer les risques de fêlure du BeO, tout en permettant le brasage à haute température, en diminuant l'épaisseur du métal de l'embase dans la partie de celle-ci située entre le BeO et un disque de métal approprié que l'on dispose dans un évidement de cette embase.

Le support selon l'invention comporte un premier élément en oxyde de béryllium, soudé par une grande face à un deuxième élément en métal à coefficient de dilatation thermique plus grand que celui du BeO. Il est caractérisé en ce que le deuxième élément comporte en son centre un évidement aménagé à l'opposé de la face soudée au premier élément, ledit évidement étant destiné à loger au moins partiellement un disque de métal de coefficient de dilatation thermique inférieur ou égal à celui de l'oxyde de béryllium.

L'invention sera mieux comprise, et d'autres caractéristiques apparaîtront, au moyen de la description qui suit, et des dessins qui l'accompagnent, parmi lesquels :

la figure 1 représente, en coupe schématique, un exemple de réalisation de l'invention ;

la figure 2 représente en (a) une vue en plan et en (b) une vue de profil d'une partie du dispositif de la figure 1.

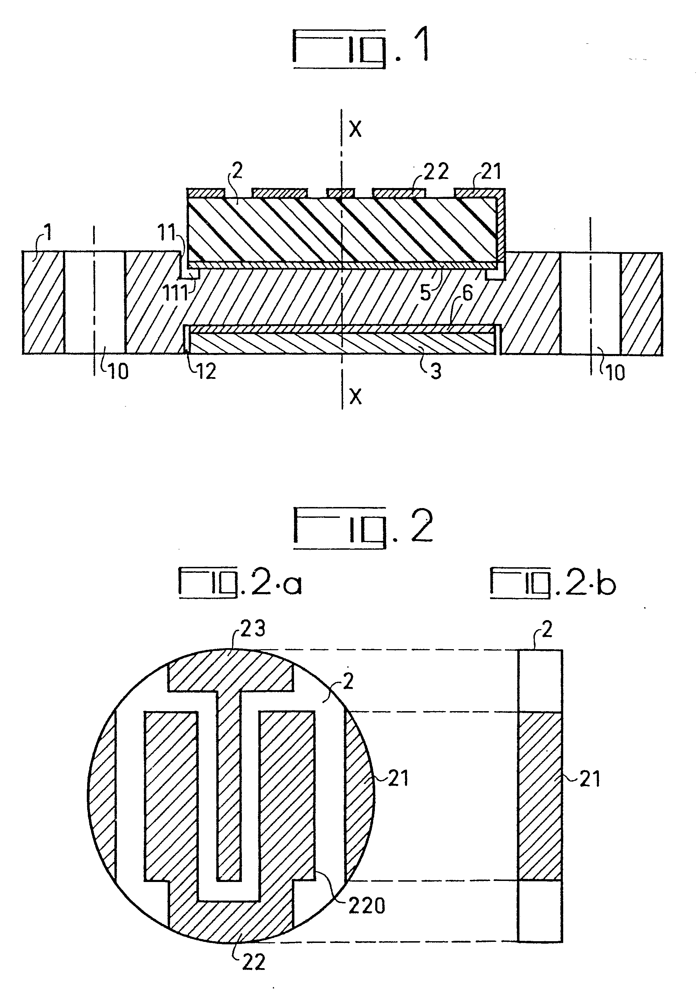

Dans l'exemple choisi, représenté figure 1, une embase 1 en cuivre comporte une partie centrale de forme arrondie, sensiblement de révolution autour d'un axe XX et deux oreilles perforées de trous cylindriques d'axes 10.

Dans sa partie centrale, l'embase 1 est amincie par deux évidements 11 et 12.

Un disque 2 d'oxyde de béryllium est soudé par un disque de brasure 5 dans l'évidement circulaire 11. Un disque 3 de molybdène ou de tungstène est soudé dans l'évidement 12 par un disque de brasure 6. Le disque 2 émerge nettement de l'évidement 11 ; il comporte des métallisations 21, 22, etc. L'une de ces métallisations couvre une partie de la face supérieure du disque ainsi qu'une partie de sa tranche (voir en b, figure 2). Le disque 3 affleure sans dépasser la face de l'embase qui lui est adjacente.

Une gorge circulaire 111 de dégagement est aménagée à la périphérie de l'évidement 11. Elle facilite la compression de la partie centrale de l'embase, lors d'une élévation de température, par le jeu des forces de liaison entre les disques 2 et 3 et cette partie de l'embase. Elle évite à la brasure de remonter sur la tranche 2 de BeO.

Figure 2 on a représenté en (a) la face métallisée du disque 2 en oxyde de béryllium, et en (b), la tranche de ce disque partiellement métallisée (partie hachurée). Cette partie métallisée constitue le retour de masse de la métallisation 21 représentée également par des hachures sur la vue en plan.

Les métallisations représentées à titre d'exemple conviennent au montage d'un transistor comportant quatre pastilles identiques soudées deux à deux sur les plages 220 de la métallisation la plus large. La même métallisation 22 fournit, à sa partie périphérique une plage de soudure pour une large bande de connexion (non représentée). Cette connexion est par exemple celle du collecteur du transistor, dans le cas où cette électrode est reliée à la face arrière de la pastille soudée sur la métallisation 22.

Les deux autres électrodes d'entrée et/ou de sortie du transistor sont reliées par fils de connexion aux métallisations 21 et 23.

Dans le cas d'un transistor de puissance totale de 250 watts, les dimensions des parties essentielles sont les suivantes :

— Embase 1 :
    diamètre au centre : 14 mm
    épaisseur au centre : 1,6 mm
— Disque 2 :
    BeO : diamètre 14 mm,
        épaisseur 1,6 mm
— Disque 3 :
    molybdène : diamètre 14 mm
        épaisseur 0,5 mm.

Le dispositif constitué par les parties assemblées constitue un boîtier. Le boîtier proprement dit comporte un capot de protection (non représenté) coiffant la partie centrale, c'est-à-dire les pastilles et les fils de connexion particulièrement vulnérables.

## Revendications

1. Support isolateur électrique à faible résistance thermique, comportant un premier élément (2) en oxyde de béryllium (BeO), soudé par une grande face à un deuxième élément (1) en métal à coefficient de dilatation thermique plus grand que celui du BeO, caractérisé en ce que le deuxième élément (1) comporte en son centre un évidement (12) aménagé à l'opposé de la face soudée au premier élément (2) destiné à loger au moins partiellement un disque (3) de métal de coefficient de dilatation thermique inférieur ou égal à celui dudit oxyde de béryllium.

2. Support suivant la revendication 1, caractérisé en ce que le disque (3) de métal est en molybdène ou en tungstène.

3. Support suivant la revendication 1, caractérisé en ce que le disque (3) de métal est en titane ou en alliage métallique à coefficient de dilatation thermique équivalent.

4. Support suivant la revendication 1, caractérisé en ce que le disque (3) de métal affleure sans dépasser la face de l'embase qui lui est adjacente.

5. Boîtier pour composant électronique, comportant un support suivant l'une quelconque des revendications 1 à 4, caractérisé en ce qu'il comporte en outre un capot de protection.

## Claims

1. Electrically isolating carrier having a low thermal resistance, comprising a first element (2) made of an electrically isolating and heatconducting material, said first element being welded with a large surface thereof to a second element (1) made of a metal having a thermal expansion coefficient greater than that of said material, characterized in that said second element is provided in its center with a recess (12) opposite to the face welded to said first element (2) and adapted to receive at least partially a piece (3) made of a metal the thermal expansion coefficient of which is lower than, or equal to, that of said material.

2. Carrier according to claim 1, characterized in that said first element (2) is made of beryllium oxide, while said metallic piece (3) is made of molybdenum or tungsten.

3. Carrier according to claim 1, characterized in that said first element (2) is made of beryllium oxide, while said metallic piece (3) is made of titanium or an alloy having an equivalent thermal expansion coefficient.

4. Carrier according to claim 1, characterized in that said metallic piece (3) is constituted by a disk mounted in said recess.

5. Housing for an electronic component, comprising a carrier according to any one of claims 1 to 4, characterized in that it further comprises a protecting cap.

## Ansprüche

1. Elektrisch isolierender Träger mit geringem thermischen Widerstand, umfassend ein erstes aus elektrisch isolierendem und ein hohe Wärmeleitfähigkeit aufweisendem Material bestehendes erstes Element (2), das mit einer grossen Oberfläche an ein zweites Element (1) angeschweisst ist, welches aus einem Metall besteht, das einen grösseren Wärmedehnungskoeffizienten besitzt, als das genannte Material, dadurch gekennzeichnet, dass das zweite Element (1) in seinem Zentrum eine Ausnehmung (12) aufweist, die der mit dem ersten Element (2) verschweissten Ober-

fläche gegenüber liegt und dazu dient, wenigstens teilweise ein metallisches Stück (3) aufzunehmen, dessen Wärmedehnungskoeffizient niedriger ist als derjenige des genannten Materials, oder dem Wärmedehnungskoeffizienten dieses Materials gleich ist.

2. Träger nach Anspruch 1, dadurch gekennzeichnet, dass das erste Element (2) aus Berylliumoxyd besteht, während das metallische Stück (3) aus Molybdän oder Wolfram besteht.

3. Träger nach Anspruch 1, dadurch gekennzeichnet, dass das erste Element (2) aus Berylliumoxyd besteht, während das metallische Stück (3) aus Titan oder aus einer Legierung mit equivalentem Wärmedehnungskoeffizienten besteht.

4. Träger nach Anspruch 1, dadurch gekennzeichnet, dass das metallische Stück (3) aus einer in der Ausnehmung angeordneten Scheibe besteht.

5. Gehäuse für einen elektronischen Bauteil mit einem Träger nach einem der Ansprüche 1 bis 4, dadurch gekennzeichnet, dass es ferner eine Schutzhaube aufweist.

Fig.1

Fig.2

Fig.2·a  Fig.2·b